# EUROPEAN PATENT APPLICATION

(11) **EP 4 475 433 A1**
(43) Date of publication of application: **11.12.2024**
(21) Application number: 23767015.3
(22) Date of filing: 01.02.2023
(51) Int. Cl.: H03F 1/02, H03F 1/56, H03F 3/189, H03F 3/21, H01P 5/16, H01Q 5/20, H01P 5/18

(54) **ELECTRONIC DEVICE COMPRISING POWER AMPLIFIER FOR RF SIGNAL**

(30) Priority: 07.03.2022 KR 20220028771; 05.04.2022 KR 20220042302; 04.10.2022 KR 20220126617; 11.11.2022 KR 20220150866
(71) Applicant: Samsung Electronics Co., Ltd., Suwon-si, Gyeonggi-do 16677 (KR)
(72) Inventor: JUNG, Joonho, Suwon-si, Gyeonggi-do 16677 (KR); PARK, Hyunchul, Suwon-si, Gyeonggi-do 16677 (KR); BAEK, Seungjae, Suwon-si, Gyeonggi-do 16677 (KR); LEE, Jooseok, Suwon-si, Gyeonggi-do 16677 (KR)
(74) Representative: HGF
(86) International application number: PCT/KR2023/001464
(87) International publication number: WO 2023/171910

(57) **Abstract**

An electronic device, according to various embodiments, may comprise: a power amplifier for amplifying an input signal; an antenna module for transmitting an RF signal amplified in a circuit of the power amplifier; and a communication processor for controlling the power amplifier and the antenna module. Other various embodiments are possible.

## Description

### [Technical Field]

The disclosure relates to an electronic device, and, for example, to an electronic device including a power amplifier configured to amplify an RF signal.

### [Background Art]

To meet the demand for wireless data traffic having increased since deployment of 4th generation (4G) communication systems, efforts have been made to develop an improved 5th generation (5G) or pre-5G communication system. Therefore, the 5G or pre-5G communication system is also called a "beyond 4G network" communication system or a "post LTE" system. The 5G communication system is considered to be implemented in ultrahigh frequency (mmWave) bands (e.g., 6GHz or higher bands) so as to accomplish higher data rates. To decrease the propagation loss of the radio waves and increase the transmission distance of radio waves in the ultrahigh frequency (mmWave) bands, beamforming, massive multiple-input multiple-output (massive MIMO), full dimensional MIMO (FD-MIMO), array antenna, an analog beam forming, and large scale antenna techniques have been discussed in the 5G communication system. In addition, in the 5G communication system, technical development for system network improvement is under way based on evolved small cells, advanced small cells, cloud radio access networks (cloud RANs), ultra-dense networks, device-to-device (D2D) communication, wireless backhaul, moving network, cooperative communication, coordinated multi-points (CoMPs), reception-end interference cancellation, and the like. In the 5G system, hybrid FSK and QAM modulation (FQAM) and sliding window superposition coding (SWSC) as an advanced coding modulation (ACM) scheme, and filter bank multi carrier (FBMC), non-orthogonal multiple access (NOMA), and sparse code multiple access (SCMA) as an advanced access technology have also been developed.

When a 5G communication system uses an ultra-high frequency band (mmWave) of 6 GHz or higher, an electronic device requires an RF circuit and an antenna module to support the ultra-high frequency band. In particular, when implementing a transmitter of an RF circuit supporting 5G communication, the need for a power amplifier with high back-off efficiency is increasing due to the characteristics of the 5G OFDM modulation signal. For example, a Doherty power amplifier (Doherty PA) structure may be used.

### [Disclosure of Invention]

### [Technical Problem]

When the RF circuit of an electronic device includes a Doherty power amplifier structure, a coupler is required to generate an in-phase signal (an in-phase signal or I signal) and a quadrature signal (a quadrature signal or Q signal) from an input signal. Such a coupler may be designed so that the I signal and the Q signal have the same amplitude and a 90 degree difference in phase at the center frequency. The electronic device may use a wide bandwidth of the ultra-high frequency band of 5G communication and support a plurality of channels simultaneously. In this case, in the case of a frequency band far from the center frequency of the target frequency band, a difference in amplitude and/or phase of the I signal and the Q signal may be significantly different from the difference at the center frequency.

### [Solution to Problem]

An electronic device according to various embodiments of the disclosure (or specification, invention) may include a power amplifier configured to amplify an input signal, an antenna module configured to transmit an RF signal amplified in a circuit of the power amplifier, and a communication processor configured to control the power amplifier and the antenna module.

According to various embodiments, the power amplifier may include a coupler configured to divide a signal input from the communication processor into a first signal and a second signal, the coupler including a first inductor disposed in a first transmission path of the first signal and a second inductor disposed in a second transmission path of the second signal, and a first switch capable of varying the inductance of the first inductor.

According to various embodiments, the communication processor may be configured to turn off the first switch when the RF signal is a signal of a first frequency band, and turn on the first switch when the RF signal is a signal of a second frequency band higher than the first frequency band.

### [Advantageous Effects of Invention]

According an embodiment of the disclosure, it is possible to reduce the imbalance of amplitude and phase between an I signal and a Q signal by implementing the quadruple hybrid coupler of a power amplifier to be frequency-tunable.

### [Brief Description of Drawings]

FIG. 1 is a block diagram of an electronic device in a network environment according to various embodiments.
FIG. 2 is a block diagram of an electronic device for supporting a plurality of networks according to various embodiments.
FIG. 3 is a block diagram of an electronic device according to various embodiments.
FIG. 4 is a block diagram of an RF circuit of an electronic device according to an embodiment.
FIG. 5 is a block diagram of a power amplifier of an electronic device according to an embodiment.
FIG. 6 is a circuit diagram of an inductive coupling-based quadrature hybrid coupler according to an embodiment.
FIG. 7 is a circuit diagram of a quadruple hybrid coupler that is adjustable according to a frequency according to an embodiment.
FIG. 8 is a circuit diagram of a quadruple hybrid coupler that is adjustable according to a frequency according to an embodiment.
FIG. 9 is an equivalent circuit diagram of a frequency band reconfigurable part according to an embodiment.
FIG. 10 is a graph illustrating switch control according to a frequency band according to an embodiment.
FIG. 11 is a graph illustrating insertion loss according to a frequency according to an embodiment.

### [Mode for the Invention]

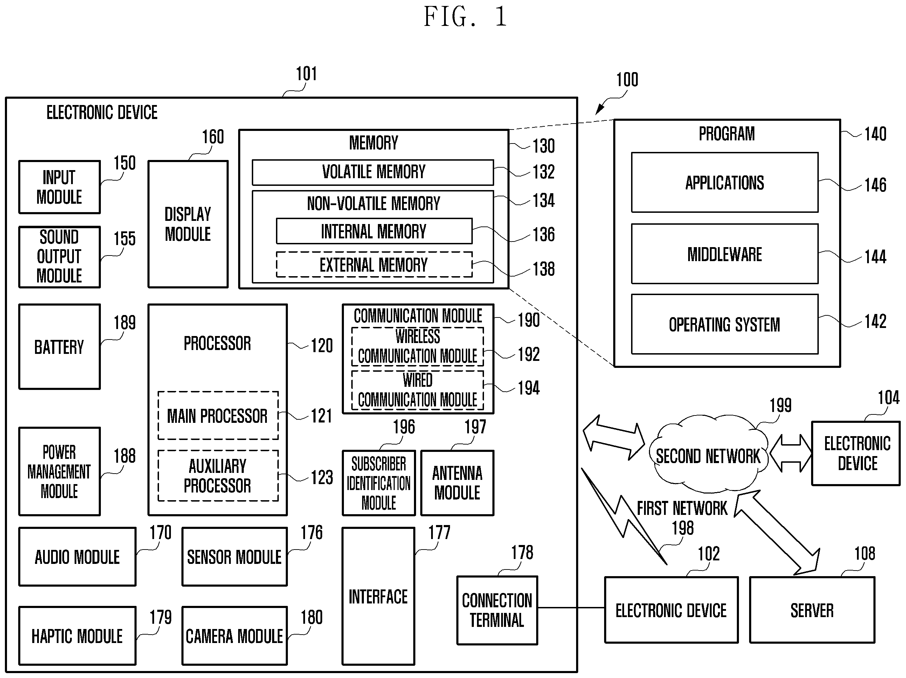

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

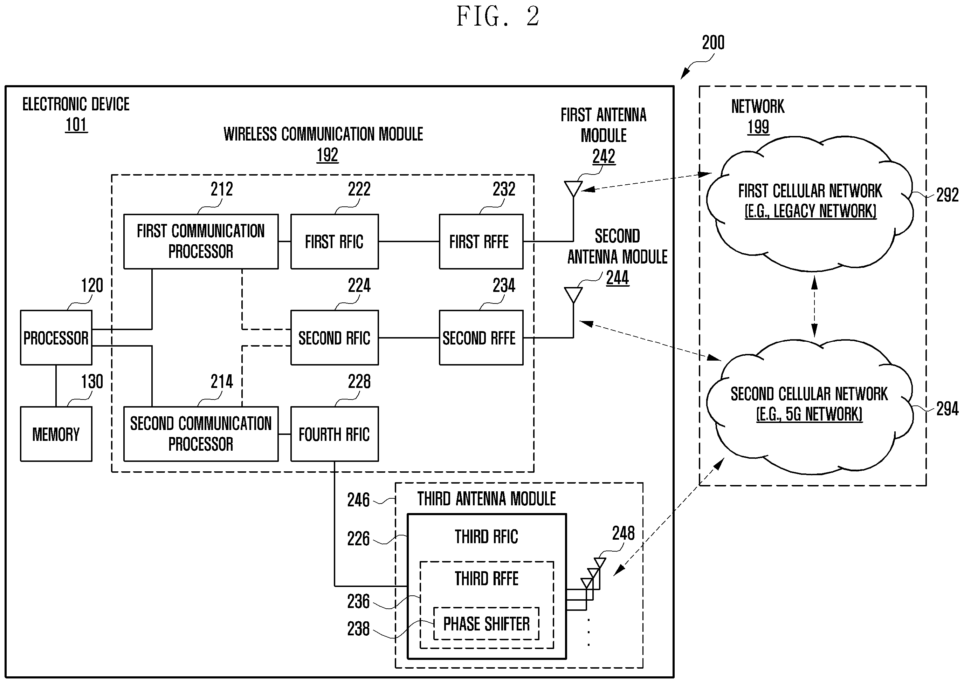

FIG. 2 is a block diagram of an electronic device for supporting a plurality of networks according to various embodiments.

Referring to FIG. 2, the electronic device (or a user equipment) 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include a processor 120 and a memory 130. A network 199 may include a first network 292 and a second network 294. According to another embodiment, the electronic device 101 may further include at least one of the components illustrated in FIG. 1, and the network 199 may further include at least one other network. According to an embodiment, the first communication processor 212, the second communication processor 214, the first RFIC 222, the second RFIC 224, the fourth RFIC 228, the first RFFE 232, and the second RFFE 234 may compose at least a part of a wireless communication module 192. According to another embodiment, the fourth RFIC 228 may be omitted or included as part of the third RFIC 226.

According to various embodiments, the first communication processor 212 may establish a communication channel of a band to be used for wireless communication with the first network 292, and support 4G network communication through the established communication channel. According to various embodiments, the first network may be a 4G network including a second generation (2G), 3G, 4G, or long-term evolution (LTE) network. The second communication processor 214 may establish a communication channel corresponding to a specified band (e.g., about 6 GHz to about 60 GHz) among bands to be used for wireless communication with the second network 294, and support 5G network communication through the established communication channel. According to various embodiments, the second network 294 may be a 5G network defined by 3GPP. In addition, according to an embodiment, the first communication processor 212 or the second communication processor 214 may establish a communication channel corresponding to another specified band (e.g., about 6 GHz or less) among bands to be used for wireless communication with the second network 294, and support 5G network communication through the established communication channel. According to an embodiment, the first communication processor 212 and the second communication processor 214 may be implemented on a single chip or in a single package. According to various embodiments, the first communication processor 212 or the second communication processor 214 may be composed on a single chip or in a single package with the processor 120, the auxiliary processor 123 or the communication module 190.

According to various embodiments, upon transmission, the first RFIC 222 may convert the baseband signal generated by the first communication processor 212 into a radio frequency (RF) signal of about 700 MHz to about 3 GHz used in the first network 292 (e.g., a 4G network). Upon reception, an RF signal may be obtained from the first network 292 (e.g., a 4G network) through an antenna (e.g., the first antenna module 242), and preprocessed through an RFFE (e.g., the first RFFE 232). The first RFIC 222 may convert the preprocessed RF signal into a baseband signal to be processed by the first communication processor 212.

According to various embodiments, upon transmission, the second RFIC 224 may convert the baseband signal generated by the first communication processor 212 or the second communication processor 214 into an RF signal (hereinafter referred to as a 5G sub-6 RF signal) of a sub-6 band (e.g., about 6 GHz or less) used in the second network 294 (e.g., a 5G network). Upon reception, a 5G sub-6 RF signal may be obtained from the second network 294 (e.g., a 5G network) through an antenna (e.g., the second antenna module 244), and preprocessed through an RFFE (e.g., the second RFFE 234). The second RFIC 224 may convert the preprocessed 5G sub-6 RF signal into a baseband signal to be processed by a corresponding communication processor among the first communication processor 212 and the second communication processor 214.

According to various embodiments, the third RFIC 226 may convert the baseband signal generated by the second communication processor 214 into an RF signal (hereinafter referred to as a 5G above-6 RF signal) of a 5G above-6 band (e.g., about 6 GHz to about 60 GHz) used in the second network 294 (e.g., a 5G network). Upon reception, a 5G above-6 RF signal may be obtained from the second network 294 (e.g., a 5G network) through an antenna (e.g., the antenna 248), and preprocessed through the third RFFE 236. The third RFIC 226 may convert the preprocessed 5G above-6 RF signal into a baseband signal to be processed by the second communication processor 214. According to an embodiment, the third RFFE 236 may be composed as part of the third RFIC 226.

According to an embodiment, the electronic device 101 may include the fourth RFIC 228 separately from or at least as part of the third RFIC 226. In this case, the fourth RFIC 228 may convert the baseband signal generated by the second communication processor 214 into an RF signal (hereinafter referred to as an IF signal) of an intermediate frequency band (e.g., about 9 GHz to about 11 GHz) and transfer the IF signal to the third RFIC 226. The third RFIC 226 may convert the IF signal into a 5G above-6 RF signal. Upon reception, the 5G above-6 RF signal may be received from the second network 294 (e.g., a 5G network) through an antenna (e.g., the antenna 248) and converted to an IF signal by the third RFIC 226. The fourth RFIC 228 may convert the IF signal into a baseband signal so that the second communication processor 214 may process the same.

According to an embodiment, the first RFIC 222 and the second RFIC 224 may be implemented as a single chip or at least part of a single package. According to an embodiment, the first RFFE 232 and the second RFFE 234 may be implemented as a single chip or at least part of a single package. According to an embodiment, at least one antenna module among the first antenna module 242 and the second antenna module 244 may be omitted or combined with another antenna module to process RF signals of a plurality of corresponding bands.

According to an embodiment, the third RFIC 226 and the antenna 248 may be disposed on the same substrate to compose third antenna module 246. For example, the wireless communication module 192 or the processor 120 may be disposed on a first substrate (e.g., main PCB). In this case, the third antenna module 246 may be composed by disposing the third RFIC 226 on a partial area (e.g., a lower surface) of a second substrate (e.g., a sub PCB) separate from the first substrate, and the antenna 248 on another partial area (e.g., an upper surface). By disposing the third RFIC 226 and the antenna 248 on the same substrate, it is possible to reduce the length of the transmission line therebetween. For example, loss (e.g., attenuation) of a signal of a high frequency band (e.g., about 6 GHz to about 60 GHz) used in 5G network communication by a transmission line may be reduced. As a result, the electronic device 101 may improve the quality or speed of communication with the second network 294 (e.g., a 5G network).

According to an embodiment, the antenna 248 may be composed as an antenna array including a plurality of antenna elements that may be used for beamforming. In this case, the third RFIC 226 may include, for example, a plurality of phase shifters 238 corresponding to a plurality of antenna elements as a part of the third RFFE 236. Upon transmission, each of the plurality of phase shifters 238 may convert the phase of a 5G above-6 RF signal to be transmitted to the outside (e.g., a base station of a 5G network) of the electronic device 101 through a corresponding antenna element. Upon reception, each of the plurality of phase shifters 238 may convert the phase of the 5G above-6 RF signal received from the outside through the corresponding antenna element into the same or substantially the same phase. This enables transmission or reception through beamforming between the electronic device 101 and the outside.

The second network 294 (e.g., a 5G network) may be operated independently (e.g., standalone (SA)) or connected to the first network 292 (e.g., a 4G network) (e.g., non-standalone (NSA)). For example, a 5G network may include only an access network (e.g., a 5G radio access network (RAN) or a next generation RAN (NG RAN)) but no core network (e.g., a next generation core (NGC)). In this case, after accessing the access network of the 5G network, the electronic device 101 may access an external network (e.g., the Internet) under the control of a core network (e.g., evolved packed core (EPC)) of the 4G network. Protocol information (e.g., LTE protocol information) for communication with a 4G network or protocol information (e.g., new radio (NR) protocol information) for communication with a 5G network may be stored in the memory 230 and may be accessed by other components (e.g., the processor 120, the first communication processor 212, or the second communication processor 214).

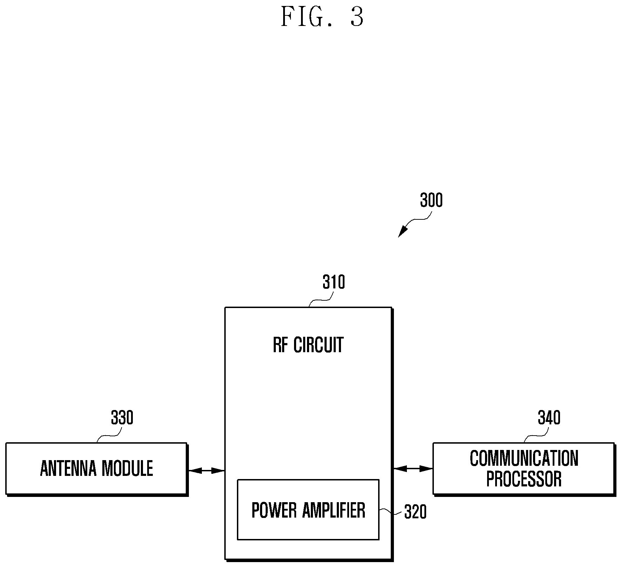

FIG. 3 is a block diagram of an electronic device according to various embodiments.

Referring to FIG. 3, the electronic device 300 may include a communication processor 340, an RF circuit 310, and an antenna module 330, and at least some of the illustrated configurations may be omitted. The electronic device 300 may further include at least some of the configurations and/or functions of the electronic device 101 of FIGS. 1 and 2.

According to various embodiments, the antenna module 330 may transmit a radio frequency (RF) signal to the outside or receive an RF signal transmitted from the outside. The electronic device 300 may include a plurality of antenna modules 330 supporting various frequency bands, and may include, for example, the antenna module 330 (e.g., the second antenna module 244 of FIG. 2) supporting a mmWave band of 6 GHz or higher. According to an embodiment, the antenna module 330 may include a phased array antenna. The phased array antenna is an antenna that controls the phase of a plurality of antenna elements differently and then adjusts the steering angle by using interference, and may be used for beamforming of 5G communication.

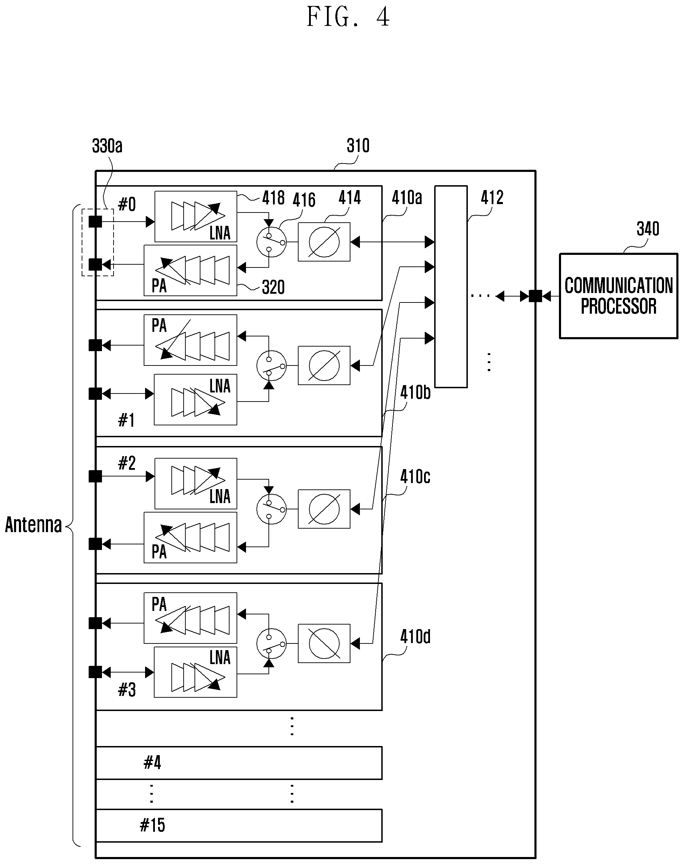

According to various embodiments, the RF circuit 310 may process a signal received from the antenna module 330 or output through the antenna module 330. The RF circuit 310 may perform a function of amplifying a baseband signal input from the communication processor 340 into a radio frequency (RF) signal or attenuating an RF signal received from the antenna module 330 into a baseband signal. The RF circuit 310 may include at least some of the configurations and/or functions of the second RFIC 234 of FIG. 2. The detailed structure of the RF circuit 310 will be described with reference to FIG. 4.

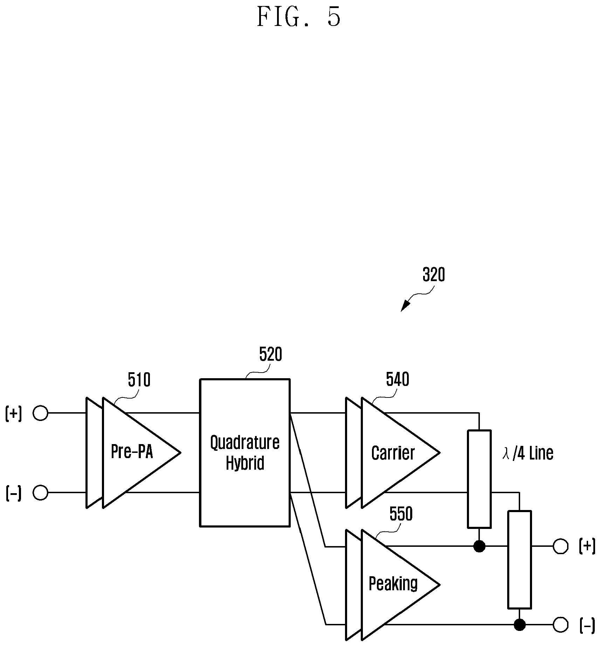

According to various embodiments, the RF circuit 310 may include a power amplifier 320 that amplifies an RF signal. When implementing a transmitter of the RF circuit 310 used in the mmWave band, a power amplifier 320 having high back-off efficiency may be required due to the characteristics of a 5G OFDM modulation signal. According to an embodiment, the power amplifier 320 may include a Doherty amplifier structure. The Doherty amplifier includes two amplifiers (a carrier amplifier and a peaking amplifier), and an in-phase signal (I signal) may be input to the carrier amplifier, and a quadrature signal (Q signal) may be input to the peaking amplifier. The Doherty amplifier may include a coupler for generating an I signal and a Q signal having a phase difference of 90 degrees from each other from an input signal. The RF circuit 310 may include a plurality of sub-circuits corresponding to each antenna element. The structure of the power amplifier 320 according to various embodiments will be described in more detail with reference to FIG. 5.

According to various embodiments, the power amplifier 320 having a Doherty amplifier structure may include a coupler that generates a first signal (e.g., an I signal) and a second signal (e.g., a Q signal). According to an embodiment, the coupler may be implemented as a quadrature hybrid coupler (or a hybrid coupler, a 3dB quadrature coupler, or a branch line coupler). According to an embodiment, a coupler may be designed by using inductive coupling between different metal layers in a multi-layer semiconductor process, and accordingly, the coupler may be designed in a narrow area.

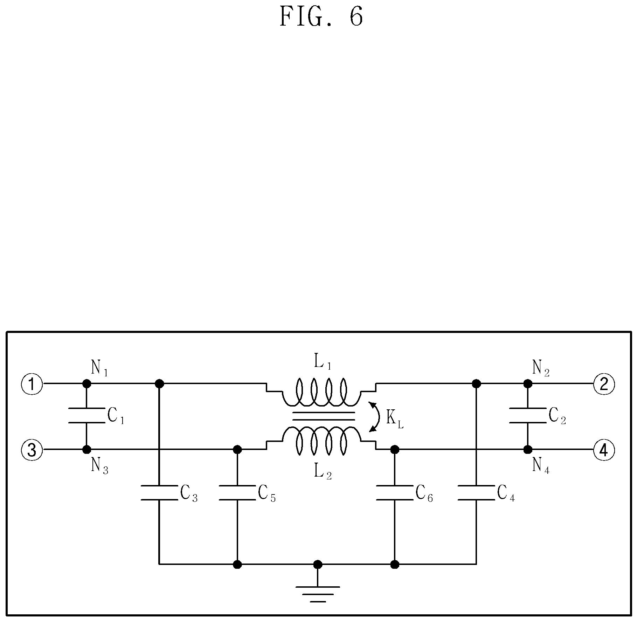

According to various embodiments, the coupler may include a first inductor disposed in a first transmission path of the first signal and a second inductor disposed in a second transmission path of the second signal. The coupler may further include at least one capacitor. The first inductor, the second inductor, and the capacitor may be designed such that the electrical lengths of the first transmission path and the second transmission path are λ/4 (or 90 degrees) in a specific frequency band. The structure of the coupler according to various embodiments will be described in more detail with reference to FIG. 6.

According to various embodiments, the communication processor 340 may perform various control operations for establishing a communication channel and wireless communication with an external device (e.g., a 5G base station) using the established channel. The communication processor 340 may transmit a baseband signal to the RF circuit 310, and the baseband signal may be amplified to an RF signal by the RF circuit 310 and transmitted to the outside through the antenna module 330. There is no limitation on the control operation of the communication processor 340 for the RF circuit 310 and/or the antenna module 330. The communication processor 340 may include at least some of the configuration and/or functions of the second communication processor 214 of FIG. 2.

According to various embodiments, the electronic device 300 may support a plurality of frequency bands. For example, the electronic device 300 may support adjacent bands in the mmWave band, such as n257 and n258, among the frequency bands of 5G NR. For example, the n257 band may use 26.50 to 29.50 GHz in the uplink and downlink, and may use channel bandwidths of 50, 100, 200, and 400MHz. The n258 band may use 24.25 to 27.50 GHz, and may use channel bandwidths of 50, 100, 200, and 400MHz. The frequency band supported by the RF circuit 310 of the electronic device 300 is not limited to the above-described n257 and n258, and may support other adj acent and partially overlapping frequency bands among the mmWave bands. When the electronic device 300 uses a wide band such as n257 and n258, an amplitude/phase imbalance of the I signal and the Q signal output through the coupler at both end frequencies may occur. In order to minimize such an imbalance, the electronic device 300 according to various embodiments may include a band reconfigurable part including at least one switch connected in parallel to at least a part of the coupler and capable of being turned on/off.

According to various embodiments, the band reconfigurable part of the power amplifier 320 may include at least one switch capable of on/off control.

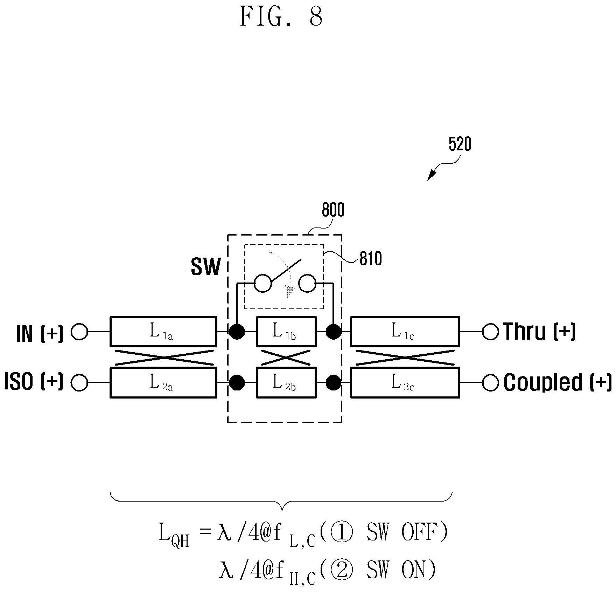

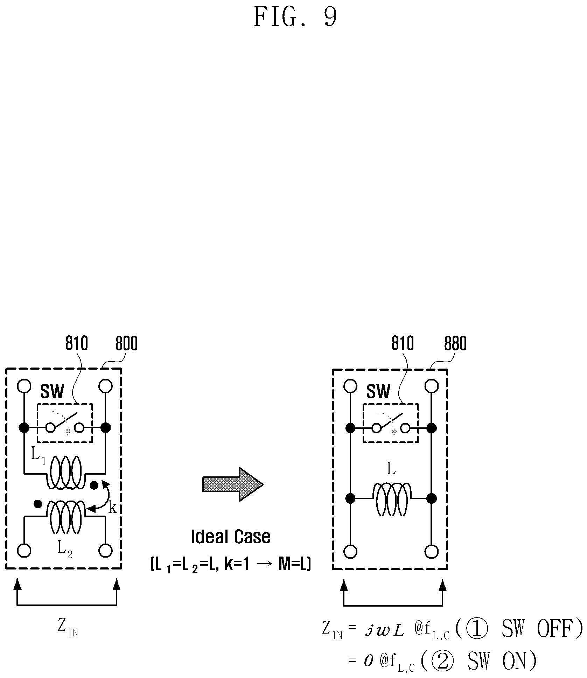

According to an embodiment, the power amplifier 320 may include a band reconfigurable part of a one-switch structure including a first switch capable of varying the inductance of the first inductor of the coupler. According to an embodiment, the first inductor may be composed of a plurality of inductor elements, and the first switch may be connected in parallel to any one of the plurality of inductor elements. Accordingly, when the first switch is turned on, the inductance of the first inductor may be reduced. The embodiment will be described in more detail with reference to FIGS. 8 and 9.

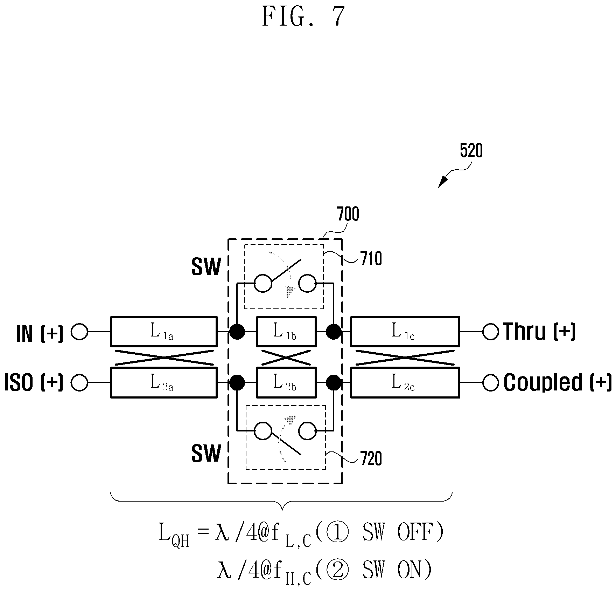

According to another embodiment, the power amplifier 320 may include a band reconfigurable part of a two-switch structure including a first switch capable of varying the inductance of the first inductor of the coupler and a second switch capable of varying the inductance of the second inductor of the coupler. According to an embodiment, the first inductor may be composed of a plurality of inductor elements, and the first switch may be connected in parallel to any one of the plurality of inductor elements. According to an embodiment, the second inductor may be composed of a plurality of inductor elements, and the second switch may be connected in parallel to any one of the plurality of inductor elements. The embodiment will be described in more detail with reference to FIG. 7.

According to various embodiments, the communication processor 340 may be configured to turn off a switch (e.g., the first switch, or the first switch and the second switch) of the band reconfigurable part when the RF signal is a signal of the first frequency band (e.g., n258), and to turn on the switch when the RF signal is a signal of the second frequency band (e.g., n257).

According to an embodiment, when the first switch (or the first switch and the second switch) of the coupler is turned off, the electrical lengths of the first transmission path of the first signal and the second transmission path of the second signal at the center frequency of the first frequency band may be λ/4 (or 90 degrees). Accordingly, the first signal and the second signal have the same amplitude and a phase difference of 90 degrees at the center frequency of the first frequency band, and the amplitude/phase imbalance of the first signal and the second signal may be reduced even near the frequencies at both ends of the first frequency band.

According to an embodiment, when the first switch (or the first switch and the second switch) of the coupler is turned on, the electrical lengths of the first transmission path of the first signal and the second transmission path of the second signal at the center frequency of the second frequency band may be λ/4 (or 90 degrees). Accordingly, the first signal and the second signal have the same amplitude and a phase difference of 90 degrees at the center frequency of the second frequency band, and the amplitude/phase imbalance of the first signal and the second signal may be reduced even near the frequencies at both ends of the second frequency band.

When a frequency-tunable quadrature hybrid coupler proposed in the disclosure is applied to a Doherty power amplifier, a broadband Doherty power amplifier capable of simultaneously covering adjacent bands among 5G NR bands may be implemented.

FIG. 4 is a block diagram of an RF circuit of an electronic device according to an embodiment.

According to an embodiment, the electronic device (e.g., the electronic device 300 of FIG. 3) may include a phased array antenna. The phased array antenna is an antenna that controls the phase of a plurality of antenna elements (e.g., 330a) differently and then adjusts the steering angle by using interference, and may be used for beamforming of 5G communication.

According to an embodiment, the RF circuit 310 may be designed to process a signal transmitted or received from each antenna element of the antenna. The RF circuit 310 may be developed using a Si-based CMOS (complementary metal-oxide semiconductor) or SiGe Bi-CMOS process, and accordingly, multi-chain RF phase arrays may be integrated and designed.

Referring to FIG. 4, the electronic device may include the RF circuit 310 (or RFIC) in the form of a multi-chain (e.g., 16 chains) including a total of 16 antenna elements (e.g., 330a). The RF circuit 310 may include a phase shifter 414, a switch 416, a low noise amplifier (LNA) 418, and a power amplifier (PA) 320 corresponding to each antenna element. A signal input from the communication processor 340 to the RF circuit 310 may be divided to each antenna element by a combiner/divider 412, and the signal received from each antenna element may be combined by the combiner/divider 412 to be input to the communication processor 340. The configuration and/or functions of the switch 416, the low noise amplifier 418, and the power amplifier 320 included in each of the sub-circuit 410a, 410b, 410c, and 410d may be identical to each other.

According to an embodiment, the phase shifter 414 may shift the phase of the input signal divided by the combiner/divider 412. The phase of the signal input to the sub-circuit corresponding to each antenna element may be the same, and each phase shifter 414 may convert the phase by a predetermined angle. Accordingly, the steering angle may be adjusted by adjusting the phase of the RF signal output from each antenna element 330a.

According to an embodiment, the switch 416 may be disposed between the phase shifter 414, the low noise amplifier 418, and the power amplifier 320, and may switch paths of the Tx signal and the Rx signal.

According to an embodiment, the signal received from the antenna element 330a may be input to the low noise amplifier 418. The signal amplified by the low noise amplifier 418 may be input to the communication processor 340 through the combiner/divider 412

According to an embodiment, the power amplifier 320 may amplify an input signal and output the amplified signal to the antenna element 330a. The power amplifier 320 may have a form in which a plurality of amplifiers are connected in series to increase gain, or a plurality of amplifiers are connected in parallel to increase maximum power.

According to an embodiment, the power amplifier 320 may include a Doherty amplifier structure. The Doherty amplifier may be implemented with a relatively simple circuit, has high power back-off efficiency, has no additional baseband calculation, and/or may be used in the power amplifier 320 of the RF circuit 310 due to high linearity through bias optimization. The Doherty amplifier may include two amplifiers (a carrier amplifier and a peaking amplifier), and an in-phase signal (I signal) may be input to the carrier amplifier, and a quadrature signal (Q signal) may be input to the peaking amplifier. The Doherty amplifier may include a coupler for generating an I signal and a Q signal having a phase difference of 90 degrees from the input signal.

FIG. 5 is a block diagram of a power amplifier of an electronic device according to an embodiment.

Referring to FIG. 5, the power amplifier 320 (e.g., the power amplifier 320 of FIGS. 3 and 4) may include a pre-amplifier (pre-PA) 510, a coupler 520, a carrier amplifier 540, and a peaking amplifier 550. According to an embodiment, the power amplifier 320 may include a Doherty amplifier structure. The power amplifier 320 may be a power amplifier 320 included in a sub-circuit (e.g., 410a) corresponding to each antenna element (e.g., 330a) of the RF circuit 310 of FIG. 4.

According to an embodiment, the RF circuit of an electronic device (e.g., the electronic device 300 of FIG. 3) may support 5G NR communication, and may also support adjacent bands in the mmWave band, such as n257 and n258, among the frequency bands of 5G NR. For example, the n257 band may use 26.50 to 29.50 GHz in the uplink and downlink, and may use channel bandwidths of 50, 100, 200, and 400MHz. The n258 band may use 24.25 to 27.50 GHz, and may use channel bandwidths of 50, 100, 200, and 400MHz. The frequency band supported by the RF circuit of the electronic device is not limited to the above-described n257 and n258, and may support other adjacent and partially overlapping frequency bands among the mmWave bands.

According to an embodiment, a signal input to an RF circuit from a communication processor may be input to the pre-amplifier (pre-PA) 510. The pre-amplifier 510 may perform a function of amplifying a signal before being input to the coupler 520 to match the level of the input signal required by the carrier amplifier 540 and the peaking amplifier 550.

According to an embodiment, the coupler 520 may divide the input signal into two signals and output each of the divided signals to the carrier amplifier 540 and the peaking amplifier 550. According to an embodiment, the coupler 520 may be a quadrature hybrid coupler, and may also be referred to as a hybrid coupler, a 3dB quadrature coupler, or a branch line coupler.

According to an embodiment, the coupler 520 may be designed by utilizing inductive coupling between different metal layers in a multi-layer semiconductor process, and accordingly, the coupler 520 may be designed in a narrow area.

According to an embodiment, the coupler 520 may generate an in-phase signal (in-phase signal or I signal) and a quadrature signal (quadrature signal or Q signal) with a phase difference of 90 degrees. The I signal and the Q signal may have the same amplitude at a specific frequency (e.g., center frequency) and a phase difference of 90 degrees.

According to an embodiment, the I signal output from the coupler 520 may be input to the carrier amplifier 540 (or main amplifier), and the carrier amplifier 540 may amplify the I signal so that the antenna module may output a signal with an appropriate maximum power. The Q signal output from the coupler 520 may be input to the peaking amplifier 550 (or sub-amplifier), and the peaking amplifier 550 may amplify the Q signal so that the antenna module may output a signal with an appropriate maximum power. According to an embodiment, the electrical length of the line between the output terminal of the carrier amplifier 540 and the output terminal of the peaking amplifier 550 at the center frequency may be λ/4 (or 90 degrees). Alternatively, the electrical length of the path of the I signal and the path of the Q signal at the center frequency may be λ/4 (or 90 degrees).

According to an embodiment, the carrier amplifier 540 may operate over the entire range of the magnitude of the input signal, and the peaking amplifier 550 may not be driven when the magnitude of the input signal is less than a predetermined level.

FIG. 6 is a circuit diagram of an inductive coupling-based quadrature hybrid coupler according to an embodiment.

According to an embodiment, a power amplifier (e.g., the power amplifier 320 of FIGS. 3, 4, and 5) may include a coupler (e.g., the coupler 520 of FIG. 5) for dividing an input signal into a first signal and a second signal. For example, the coupler may be a quadrature hybrid coupler (or a hybrid coupler, a 3dB quadrature coupler, or a branch line coupler).

FIG. 6 illustrates an example of implementing a quadrature hybrid coupler by using inductive coupling. Utilizing inductive coupling between different metal layers in a multilayer semiconductor process allows the implementation of a quadrature hybrid in a narrow area.

Referring to FIG. 6, the coupler may be configured by a four-terminal network including a first port, a second port, a third port, and a fourth port. A first capacitor C1 may be located between a first node N1 connected to the first port (input port) and a third node N3 connected to the third port (isolated port). A second capacitor C2 may be located between a second node N2 connected to the second port (through port) and a fourth node N4 connected to the fourth port (coupled port). The capacitances of the first capacitor C1 and the second capacitor C2 may be the same. A third capacitor C3 may be located between the first node N1 and the ground terminal. A fourth capacitor C4 may be located between the second node N2 and the ground terminal. A fifth capacitor C5 may be located between the third node N3 and the ground terminal. A sixth capacitor C6 may be located between the fourth node N4 and the ground terminal. The capacitances of the third capacitor C3, the fourth capacitor C4, the fifth capacitor C5, and the sixth capacitor C6 may be the same.

According to an embodiment, a first inductor L1 may be located between the first node N1 and the second node N2. A second inductor L2 may be located between the third node N3 and the fourth node N4. The first inductor L1 and the second inductor L2 may be inductively coupled. According to an embodiment, in order for the quadruple hybrid coupler to operate ideally, inductances of the first inductor L1 and the second inductor L2 may be the same, the inductive coupling coefficient kL may be 0.707 (or -0.707), and the mutual inductance may be different from the inductances of the first inductor L1 and the second inductor L2.

According to an embodiment, when a signal is input to the first port, a signal (e.g., I signal, Q signal) with a phase difference of 90 degrees may be output from the second and fourth ports. A signal may not be output from the third port.

According to an embodiment, at the center frequency where the electrical lengths of the paths of the I signal and the Q signal are λ/4 (or 90 degrees), the amplitudes of the I signal output through the second port and the Q signal output through the fourth port are the same and may be 1/2 of the amplitude of the input signal. In this way, in the case of a quadruple hybrid coupler utilizing inductive coupling, the imbalance in the phase and/or amplitude of the I signal and the Q signal may increase as the distance from the center frequency increases. Accordingly, when a quadrature hybrid coupler of this structure is applied to a Doherty power amplifier supporting the mmWave band of 5G NR (e.g., n257, n258), the operation of the Doherty power amplifier may be limited at both end frequencies of the bandwidth.

According to various embodiments of the disclosure, by introducing at least one switch into the I signal path and the Q signal path of a quadrature hybrid coupler utilizing inductive coupling, the electrical length between the I signal path and the Q signal path may be adjusted, thereby allowing the quadrature hybrid coupler to operate at multiple frequencies or in a broadband.

FIG. 7 is a circuit diagram of a quadruple hybrid coupler that is adjustable according to a frequency according to an embodiment.

FIG. 7 illustrates an embodiment of configuring a band reconfigurable part using two switches connected in parallel to a transmission path.

According to an embodiment, an electronic device (e.g., the electronic device 300 of FIG. 3) may include a power amplifier (e.g., the power amplifier 320 of FIG. 3) configured to amplify an input signal to output the amplified signal through an antenna module (e.g., the antenna module 330 of FIG. 3), and the power amplifier may include a coupler 520 for dividing the input signal into a first signal and a second signal. According to an embodiment, the power amplifier may include a first switch 710 capable of varying the inductance of a first inductor disposed in a first transmission path through which a first signal of the coupler 520 is transmitted. According to an embodiment, the power amplifier may include a second switch 720 capable of varying the inductance of a second inductor disposed in a second transmission path through which a second signal of the coupler 520 is transmitted.

Referring to FIG. 7, the coupler 520 may be configured by a four-terminal network including a first port, a second port, a third port, and a fourth port. A first inductor (e.g., the first inductor L1 of FIG. 6) may be disposed between a first node N1 connected to the first port (input port) and a second node N2 connected to the second port (through port). A second inductor (e.g., the second inductor L2 of FIG. 6) may be disposed between a third node N3 connected to the third port (isolated port) and a fourth node N4 connected to the fourth port (coupled port).

According to an embodiment, the first inductor may be composed of a plurality of inductor elements L1a, L1b, and L1c, and the plurality of inductor elements L1a, L1b, and L1c of the first inductor may be connected in series to configure one inductor L1. The second inductor may be composed of a plurality of inductor elements L2a, L2b, and L2c, and the plurality of inductor elements L2a, L2b, and L2c of the second inductor may be connected in series to configure one inductor L2.

According to an embodiment, the power amplifier may include a band reconfigurable part 700 for changing the impedance of a first transmission path of a first signal (e.g., I signal) and a second transmission path of a second signal (e.g., Q signal) for impedance matching when the frequency of the RF signal changes.

According to an embodiment, the power amplifier may include the first switch 710 connected in parallel to one (L1b) of a plurality of inductor elements L1a, L1b, and L1c of the first inductor. The first switch 710 is a transistor-based switch, and may be turned on/off by a control signal of a communication processor (e.g., the communication processor of FIG. 3), or may be turned on/off by a control signal of a separate switch control circuit. When the first switch 710 is turned off (or open), since no current flows through the path of the first switch 710, the inductance of the first transmission path may be the sum of the inductance of L1a, the inductance of L1b, and the inductance of Lie. When the first switch 710 is turned on (or short), since current flows through the path of the first switch 710, the inductance of the first transmission path may be the sum of the inductance of L1a and the inductance of Lie.

According to an embodiment, the power amplifier may include the second switch 720 connected in parallel to one (L2b) of a plurality of inductor elements L2a, L2b, and L2c of the second inductor. The second switch 720 is a transistor-based switch, and may be turned on/off by a control signal of a communication processor, or may be turned on/off by a control signal of a separate switch control circuit.

When the second switch 720 is turned off (or open), since no current flows through the path of the second switch 720, the inductance of the second transmission path may be the sum of the inductance of L2a, the inductance of L2b, and the inductance of L2c. When the second switch 720 is turned on (or short), since current flows through the path of the second switch 720, the inductance of the second transmission path may be the sum of the inductance of L2a and the inductance of L2c.

According to an embodiment, the communication processor may turn off the first switch 710 and the second switch 720 when the frequency band of the RF signal transmitted through the antenna module is the first frequency band, and may turn on the first switch 710 and the second switch 720 when the frequency band of the RF signal is the second frequency band. Here, the second frequency band is a higher frequency band than the first frequency band, and some of the first frequency band and the second frequency band may overlap each other. For example, the first frequency band is n257 band that uses 26.50 to 29.50 GHz, the second frequency band is n258 band that uses 24.25 to 27.50 GHz, and the n258 and n257 bands may overlap each other at 26.50 to 27.50 GHz.

According to an embodiment, in case that the frequency band of the RF signal is the first frequency band (e.g., n258), when the first switch 710 and the second switch 720 are turned off, the power amplifier may be designed so that the electrical length of the first transmission path of the first signal and the second transmission path of the second signal at the center frequency is λ/4 (or 90 degrees). In addition, in case that the frequency band of the RF signal is the second frequency band (n257), when the first switch 710 and the second switch 720 are turned on, the power amplifier may be designed so that the electrical length of the first transmission path of the first signal and the second transmission path of the second signal at the center frequency is λ/4 (or 90 degrees).

As the reconfigurable part 700 is implemented in the power amplifier as described above, even if the frequency of the RF signal changes, the imbalance of the amplitude and/or phase of the I signal and Q signal at both end frequencies may be minimized by changing the electrical length in the signal transmission path.

FIG. 8 is a circuit diagram of a quadruple hybrid coupler that is adjustable according to a frequency according to an embodiment.

FIG. 8 illustrates an embodiment of configuring a band reconfigurable part by using one switch connected in parallel to a transmission path.

In the case of the embodiment of FIG. 7, two switches 710 and 720 are included, but as the number of passive elements such as switches, varactors, etc. increases, there is a disadvantage that space constraints and insertion loss increase when designing a circuit. Accordingly, in the embodiment, a band reconfigurable part is configured by using only one switch, but may be configured to have an impedance matching effect of an antenna.

Referring to FIG. 8, a first inductor (e.g., the first inductor L1 of FIG. 6) may be disposed between a first node N1 connected to the first port (input port) and a second node N2 connected to the second port (through port). A second inductor (e.g., the second inductor L2 of FIG. 6) may be disposed between a third node N3 connected to the third port (isolated port) and a fourth node N4 connected to the fourth port (coupled port).

According to an embodiment, the power amplifier may include the first switch 810 connected in parallel to one (L1b) of a plurality of inductor elements L1a, L1b, and L1c of the first inductor. The first switch 810 is a transistor-based switch, and may be turned on/off by a control signal of a communication processor (e.g., the communication processor 350 of FIG. 3), or may be turned on/off by a control signal of a separate switch control circuit. When the first switch 810 is turned off (or open), since no current flows through the path of the first switch 810, the inductance of the first transmission path may be the sum of the inductance of L1a, the inductance of L1b, and the inductance of Lie. When the first switch 810 is turned on (or short), since current flows through the path of the first switch 810, the inductance of the first transmission path may be the sum of the inductance of L1a and the inductance of Lie.

According to an embodiment, since the first inductor and the second inductor are inductively coupled, on/off of the first switch 810 may also affect a change in impedance of the second transmission path.

The band reconfigurable part 800 of the embodiment may be interpreted as an equivalent circuit of a transformer with the switch 810. The equivalent circuit of a transformer with the switch 810 will be described in detail with reference to FIG. 9.

According to an embodiment, the communication processor may turn off the first switch 810 when the frequency band of the RF signal transmitted through the antenna module is the first frequency band, and may turn on the first switch 810 when the frequency band of the RF signal is the second frequency band.

According to an embodiment, in case that the frequency band of the RF signal is the first frequency band (e.g., n258), when the first switch 810 is turned off, the power amplifier may be designed so that the electrical length of the first transmission path of the first signal and the second transmission path of the second signal at the center frequency is λ/4 (or 90 degrees). In addition, in case that the frequency band of the RF signal is the second frequency band (n257), when the first switch 810 is turned on, the power amplifier may be designed so that the electrical length of the first transmission path of the first signal and the second transmission path of the second signal at the center frequency is λ/4 (or 90 degrees).

As the reconfigurable part 800 is implemented in the power amplifier as described above, even if the frequency of the RF signal changes, the imbalance of the amplitude and/or phase of the I signal and Q signal at both end frequencies may be minimized.

FIG. 9 is an equivalent circuit diagram of a frequency band reconfigurable part according to an embodiment.

FIG. 9 illustrates the band reconfigurable part 800 of FIG. 8 with the one switch structure as an equivalent circuit diagram.

According to an embodiment, when the switch 810 is off by the band reconfigurable part 800, the electronic device may operate so that the electrical length of the transmission path of the I signal and Q signal is λ/4 (or 90 degrees) in a low frequency band (e.g., n258), and when the switch 810 is on, the electronic device may operate so that the electrical length of the transmission path of the I signal and Q signal is λ/4 (or 90 degrees) in a high frequency band (e.g., n257).

According to an embodiment, the operation of the band reconfigurable part 800 may be interpreted through an equivalent circuit of a transformer with the switch 810. The equivalent circuit may be simplified to an equivalent circuit of a shunt inductor with the switch 810 through an ideal assumption that the inductance of the primary inductor L1 and the secondary inductor L2 are the same and the inductive coupling coefficient is 1 in the transformer.

Referring to FIG. 9, the inductor element L1 and the inductor element L2 may be inductively coupled. In an ideal case, the inductance of L1 and the inductance of L2 the same, and the inductive coupling coefficient k may be 1, and accordingly, the mutual inductance M may be the same as the inductances of L1 and L2.

Referring to FIG. 9, the equivalent circuit of the band reconfigurable part 800 including L1, L2 and the switch 810 may be a form in which the switch 810 and the inductor L are connected in parallel.

According to an embodiment, when the switch 810 is off by the band reconfigurable part 800, the electronic device may operate so that the electrical length of the transmission path of the I signal and Q signal is λ/4 (or 90 degrees) in a low frequency band (e.g., n258), and when the switch 810 is on, the electronic device may operate so that the electrical length of the transmission path of the I signal and Q signal is λ/4 (or 90 degrees) in a high frequency band (e.g., n257).

As described above, it may be identified that the impedance of the transmission path of the Q signal to which the switch 810 is not directly connected is also changed by the on/off operation of the switch 810 through the simplified equivalent circuit. Accordingly, unlike the embodiment of FIG. 8, even if only one switch 810 is included, a frequency-changeable quadrature hybrid may be implemented.

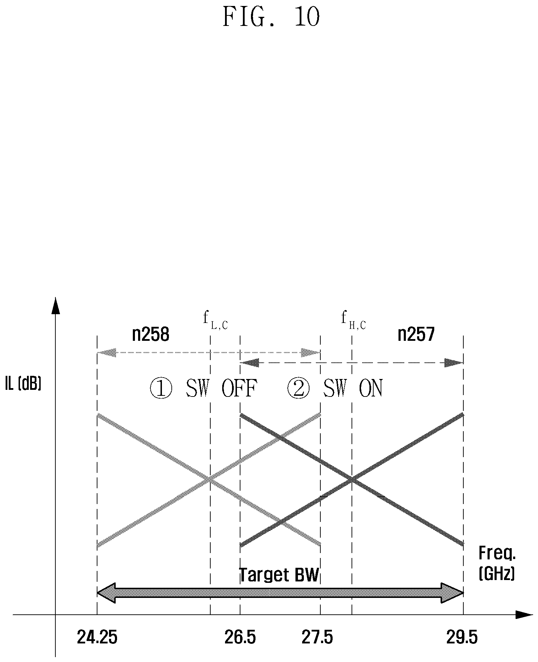

FIG. 10 is a graph illustrating switch control according to a frequency band according to an embodiment.

According to an embodiment, an electronic device (e.g., the electronic device 300 of FIG. 3) supports a plurality of mmWave bands, but may turn off the first switch (and the second switch) in a relatively low first frequency band (e.g., n258) and turn on the first switch (and the second switch) in a high second frequency band (e.g., n257). For example, the first frequency band may be the n258 band using 26.50 to 29.50 GHz, and the second frequency band may be the n257 band using 24.25 to 27.50 GHz, but is not limited thereto, and various embodiments of the disclosure may be applied to other frequency bands adjacent to each other among the mmWave bands.

FIG. 10 illustrates insertion loss according to frequencies of the I signal and the Q signal when the switch is on/off.

Referring to FIG. 10, when the switch (e.g., the first switch 710 and the second switch 720 of FIG. 7 and the first switch 810 of FIG. 8) is turned off, the insertion loss of the I signal and the insertion loss of the Q signal at 25.88 GHz, which is the center frequency of the n258 band, may be the same value of -3dB. That is, when dividing the input signal to the I signal and the Q signal in the coupler, amplitudes of the I signal and the Q signal may be divided so that they are both half the amplitude of the input signal. Accordingly, the imbalance of the I signal and the Q signal may be minimized even near the frequencies at both ends of 24.25 GHz and 27.5 GHz of the n258 band.

Referring to FIG. 10, when the switch is turned on, the insertion loss of the I signal and the insertion loss of the Q signal at 28 GHz, which is the center frequency of the n257 band, may be the same value of -3dB. That is, when dividing the input signal to the I signal and the Q signal in the coupler, amplitudes of the I signal and the Q signal may be divided so that they are both half the amplitude of the input signal. Accordingly, the imbalance of the I signal and the Q signal may be minimized even near the frequencies at both ends of 26.5 GHz and 29.5 GHz of the n257 band.

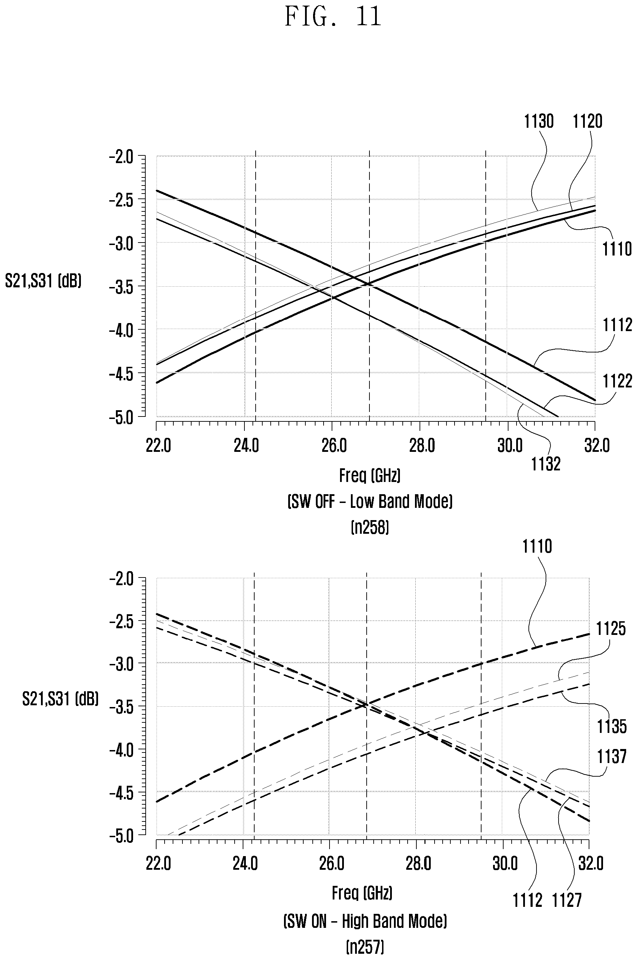

FIG. 11 is a graph illustrating insertion loss according to a frequency according to an embodiment.

FIG. 11 is a graph illustrating the insertion losses of I signals and Q signals in the first case (e.g., FIG. 6) not including a band reconfigurable part, the second case (e.g., FIG. 7) including the band reconfigurable part of the two-switch structure, and the third case (e.g., FIG. 8) including the band reconfigurable part of the one-switch structure. For example, it illustrates the insertion loss of the I and Q signals when each case is implemented by using a semiconductor process (e.g., 45 nm RFSOI CMOS process).

Referring to FIG. 11, in the first case that does not include the band reconfigurable part, the insertion losses of the I signal 1112 and the Q signal 1110 are measured to be the same at around 27 GHz which is different from the center frequency of 25.88 GHz of the n258 band and the center frequency of 28 GHz of the n257 band. In addition, it may be identified that the difference in the insertion losses of the I signal 1112 and the Q signal 1110 is large as the frequency is closer to 24.25 GHz and 27.50 GHz that are both end frequencies of the n258 band and 26.5GHz and 29.5GHz that are both end frequencies of the n257 band.

Unlike the above, the switch is turned off at n258 in the second case and third case, and accordingly, the insertion losses of the I signals 1122 and 1132 and the Q signals 1120 and 1130 may be measured identically at near the center frequency of 25.88 GHz. In addition, it may be identified that the difference in the insertion losses of the I signals 1122 and 1132 and the Q signals 1120 and 1130 is relatively low at both end frequencies of 24.25 GHz and 27.50 GHz of the n258 band.

In addition, the switch is turned on at n257 in the second case and third case, and accordingly, the insertion losses of the I signals 1127 and 1137 and the Q signals 1125 and 1135 may be measured identically at near the center frequency of 28 GHz. In addition, it may be identified that the difference in the insertion losses of the I signals 1127 and 1137 and the Q signals 1125 and 1135 is relatively low at the both end frequencies of 26.50 GHz and 29.50 GHz of the n257 band.

1 An electronic device according to various embodiments may include a power amplifier configured to amplify an input signal, an antenna module configured to transmit an RF signal amplified in a circuit of the power amplifier, and a communication processor configured to control the power amplifier and the antenna module.

According to various embodiments, the power amplifier may include a coupler configured to divide a signal input from the communication processor into a first signal and a second signal, the coupler including a first inductor disposed in a first transmission path of the first signal and a second inductor disposed in a second transmission path of the second signal, and a first switch capable of varying the inductance of the first inductor.

According to various embodiments, the communication processor may be configured to turn off the first switch when the RF signal is a signal of a first frequency band, and turn on the first switch when the RF signal is a signal of a second frequency band higher than the first frequency band.

According to various embodiments, the first inductor and the second inductor may be inductively coupled.

According to various embodiments, the first inductor may include a plurality of inductor elements connected in series, and the first switch may be connected in series to one of the plurality of inductor elements.

According to various embodiments, the inductances of the first inductor and the second inductor may decrease when the first switch is turned on.

According to various embodiments, the electrical lengths of the first transmission path and the second transmission path may be λ/4 at the center frequency of the first frequency band when the first switch is turned off.

According to various embodiments, the electrical lengths of the first transmission path and the second transmission path may be λ/4 at the center frequency of the second frequency band when the first switch is turned on.

According to various embodiments, in case that the RF signal is a signal of the first frequency band, the first signal and the second signal may have the same amplitude and a 90 degree difference in phase when the first switch is turned off.

According to various embodiments, in case that the RF signal is a signal of the second frequency band, the first signal and the second signal may have the same amplitude and a 90 degree difference in phase when the first switch is turned on.

According to various embodiments, the power amplifier may further include a carrier amplifier disposed in the first transmission path to amplify the first signal, and a peaking amplifier disposed in the second transmission path to amplify the second signal.

According to various embodiments, the second inductor may include a plurality of inductor elements connected in series, and may further include a second switch connected in series to one of the plurality of inductor elements of the second inductor.

According to various embodiments, the communication processor may be configured to turn off the first switch and the second switch when the RF signal is a signal of a first frequency band, and to turn on the first switch and the second switch when the RF signal is a signal of a second frequency band higher than the first frequency band.

According to various embodiments, the first frequency band and the second frequency band may be mmWave bands, and at least a part of the first frequency band and the second frequency band may overlap.

According to various embodiments, the coupler may be a quadrature hybrid coupler.

According to various embodiments, the power amplifier may further include a pre-amplifier (pre-PA) configured to amplify a signal input from the communication processor to output the amplified signal to the coupler.

According to various embodiments, a plurality of power amplifiers, each of which includes the coupler and the first switch, and transmits an RF signal through the antenna module may be included.

## Claims

1. An electronic device comprising:
a power amplifier configured to amplify an input signal;
an antenna module configured to transmit an RF signal amplified in a circuit of the power amplifier; and
a communication processor configured to control the power amplifier and the antenna module,
wherein the power amplifier comprises:
a coupler configured to divide a signal input from the communication processor into a first signal and a second signal, the coupler comprising a first inductor disposed in a first transmission path of the first signal and a second inductor disposed in a second transmission path of the second signal; and
a first switch capable of varying the inductance of the first inductor, and
wherein the communication processor is configured to turn off the first switch in case that the RF signal is a signal of a first frequency band, and turn on the first switch in case that the RF signal is a signal of a second frequency band higher than the first frequency band.

2. The electronic device of claim 1,
wherein the first inductor and the second inductor are inductively coupled.

3. The electronic device of claim 1 or claim 2,
wherein the first inductor comprises a plurality of inductor elements connected in series, and the first switch is connected in series to one of the plurality of inductor elements.

4. The electronic device of one of claims 1 to 3,
wherein the inductances of the first inductor and the second inductor decrease in case that the first switch is turned on.

5. The electronic device of one of claims 1 to 4,
wherein the electrical lengths of the first transmission path and the second transmission path are λ/4 at the center frequency of the first frequency band in case that the first switch is turned off.

6. The electronic device of one of claims 1 to 5,
wherein the electrical lengths of the first transmission path and the second transmission path are λ/4 at the center frequency of the second frequency band in case that the first switch is turned on.

7. The electronic device of one of claims 1 to 6,
wherein, in case that the RF signal is a signal of the first frequency band, the first signal and the second signal have the same amplitude and a 90 degree difference in phase in case that the first switch is turned off.

8. The electronic device of one of claims 1 to 7,
wherein, in case that the RF signal is a signal of the second frequency band, the first signal and the second signal have the same amplitude and a 90 degree difference in phase in case that the first switch is turned on.

9. The electronic device of one of claims 1 to 7,
wherein the power amplifier further comprises:
a carrier amplifier disposed in the first transmission path to amplify the first signal; and
a peaking amplifier disposed in the second transmission path to amplify the second signal.

10. The electronic device of claim 1,
wherein the second inductor comprises a plurality of inductor elements connected in series, and
wherein the electronic device further comprises a second switch connected in series to one of the plurality of inductor elements of the second inductor.

11. The electronic device of claim 10,
wherein the communication processor is configured to:
turn off the first switch and the second switch in case that the RF signal is a signal of a first frequency band; and
turn on the first switch and the second switch in case that the RF signal is a signal of a second frequency band higher than the first frequency band.

12. The electronic device of one of claims 1 to 11,
wherein the first frequency band and the second frequency band are mmWave bands, and at least a part of the first frequency band and the second frequency band overlap.

13. The electronic device of one of claims 1 to 11,
wherein the coupler is a quadrature hybrid coupler.

14. The electronic device of one of claims 1 to 13,
wherein the power amplifier further comprises a pre-amplifier (pre-PA) configured to amplify a signal input from the communication processor to output the amplified signal to the coupler.

15. The electronic device of one of claims 1 to 14, further comprising a plurality of power amplifiers, each of which comprises the coupler and the first switch, and transmits an RF signal through the antenna module.
